(19) Europäisches Patentamt
European Patent Office
Office européen des brevets

(11) **EP 2 980 978 A1**

(12) **EUROPEAN PATENT APPLICATION**
published in accordance with Art. 153(4) EPC

(43) Date of publication:
**03.02.2016 Bulletin 2016/05**

(51) Int Cl.:
*H02M 7/48* *(2007.01)*    *H02M 7/12* *(2006.01)*
*H02M 7/219* *(2006.01)*

(21) Application number: **13880091.7**

(22) Date of filing: **18.12.2013**

(86) International application number:
**PCT/JP2013/083816**

(87) International publication number:
**WO 2014/155864 (02.10.2014 Gazette 2014/40)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**

(30) Priority: **29.03.2013 JP 2013070975**

(71) Applicant: **Hitachi Industrial Equipment Systems
Co., Ltd.
Chiyoda-ku
Tokyo 101-0022 (JP)**

(72) Inventors:
• **MASUYAMA, Shiori
Tokyo 101-0022 (JP)**
• **KURITA, Masanori
Tokyo 101-0022 (JP)**
• **MATSUNAGA, Shunsuke
Tokyo 101-0022 (JP)**
• **MOULI, Koumei
Tokyo 101-0022 (JP)**
• **MAEDA, Nobuhisa
Tokyo 101-0022 (JP)**

(74) Representative: **Strehl Schübel-Hopf & Partner
Maximilianstrasse 54
80538 München (DE)**

(54) **ELECTRIC POWER CONVERSION DEVICE**

(57)    Provided is a method for determining a connection between a power supply input circuit and a power supply phase detection circuit and showing correct wiring to a user, in a PWM converter for three-phase power. The present invention pertains to an electric power conversion device comprising: a state data detection unit that detects state data (current, voltage) input to a regeneration converter from a three-phase power supply during switching of a main circuit terminal; a comparison unit that compares the state data detected by the state data detection unit and a predetermined threshold value; and a determination unit that determines the wiring state between a three-phase power supply entering the main circuit and a three-phase power supply entering the phase detection circuit, on the basis of the comparison results from the comparison unit.

FIG.8

**Description**

TECHNICAL FIELD

The present invention relates to an electric power conversion device.

BACKGROUND ART

As the background art of the technical field, JP-A-10-248260 is disclosed. In this publication, described is "a zero-crossing point of a phase voltage detection signal for the other one phase except a current detection signal for two phases is detected and magnitudes of the current detection signals for the two phases are compared, and thereby whether connection is normal or abnormal is determined."

CITATION LIST

PATENT LITERATURE

PATENT LITERATURE 1: JP-A-10-248260

SUMMARY OF INVENTION

TECHNICAL PROBLEM

When a method disclosed in patent literature 1 is used, miswiring can be detected in the case of a wrong order of two lines; however, the miswiring cannot be detected in the case in which a phase order is correct such as in the case in which three phases deviate. Further, a method for detecting an input current for a capacitor input and determining a phase is used; however, in the case of this method, when a microcomputer and a detection circuit do not rise up at the time of power-on, the detection cannot be performed, and therefore it is necessary to turn on power of a main circuit unit after a power supply for control is turned on separately.

SOLUTION TO PROBLEM

In the present invention, an electric power conversion device includes a state data detection unit that detects state data (current, voltage) input to a regenerative converter from a three-phase power supply during switching of a main circuit terminal, a comparison unit that compares the state data detected by the state data detection unit and a predetermined threshold, and a determination unit that determines a wiring state between the three-phase power supply entering a main circuit and the three-phase power supply entering a phase detection circuit on the basis of comparison results from the comparison unit.

ADVANTAGEOUS EFFECTS OF INVENTION

According to the present invention, provided is an electric power conversion device that is capable of confirming a phase at a power start-up without newly providing a circuit and thereby confirming whether wiring is normal or missing without causing an actual machine to perform a regenerative operation.

BRIEF DESCRIPTION OF DRAWINGS

[FIG. 1] FIG. 1 is an explanatory diagram of a configuration of a power supply regenerative converter device connected to an inverter device;
[FIG. 2] FIG. 2 is a relation diagram between a phase and a gate pulse signal;
[FIG. 3] FIG. 3 illustrates a configuration of a main circuit element;
[FIG. 4] FIG. 4 illustrates wiring at a normal time;
[FIG. 5] FIG. 5 illustrates an equivalent circuit of wiring during miswiring;
[FIG. 6] FIG. 6 is a wiring model diagram;
[FIG. 7] FIG. 7 illustrates a detection flow of the miswiring;
[FIG. 8] FIG. 8 illustrates a switching change of a main element during detection in the miswiring;

[FIG. 9] FIG. 9 is an explanatory diagram during the detection in the miswiring of a voltage detection system;

[FIG. 10] FIG. 10 is an explanatory diagram of signal processing during the miswiring;

[FIG. 11] FIG. 11 illustrates a power supply phase of each wiring pattern; and

[FIG. 12] FIG. 12 is an explanatory diagram of a miswiring detection in the case of using a voltage detection circuit.

DESCRIPTION OF EMBODIMENTS

Hereinafter, embodiments of the present invention will be described by using accompanying drawings. The embodiments will be described in detail with reference to the accompanying drawings.

FIRST EMBODIMENT

In the present embodiment, a function of detecting missing in wiring (hereinafter, miswiring) by detecting a three-phase current will be described.

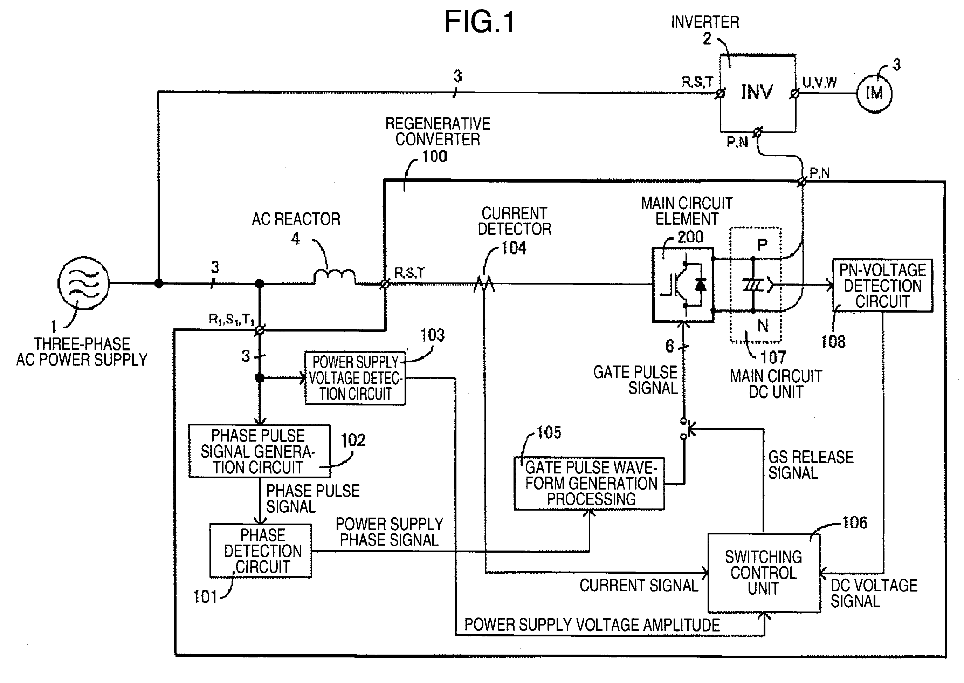

FIG. 1 illustrates an example of a configuration diagram of a power supply regenerative device of the present embodiment.

In FIG. 1, a connection configuration and operations of a 120-degree conduction regenerative converter 100 (hereinafter, a regenerative converter) and an inverter for motor control 2 (hereinafter, an inverter) will be described. In FIG. 1, an AC side of the regenerative converter 100 is connected to a three-phase AC power supply 1 (hereinafter, a power supply) via an AC reactor 4. Here, the AC side of the regenerative converter 100 may be connected to the power supply 1 via a reactor, a transformer filter, or the like. Further, a main circuit DC unit 107 on a DC side of a main circuit element 200 is connected to a DC unit of the inverter 2 that controls a motor 3. Further, an AC side of the inverter 2 is connected to the power supply 1.

The main circuit DC unit 107 holds DC power and is connected to the inverter.

In a power supply voltage detection circuit 103, a voltage of the power supply 1 is converted into an appropriate voltage by a voltage dividing resistor, a phase detecting transformer, or the like, and then is input to an A/D converter to detect a power supply voltage amplitude. This power supply voltage amplitude signal is input to a switching control unit 106.

A current detector 104 detects a current of a main circuit connected to an AC reactor 4. A value thereof is output to the switching control unit 106.

A PN-voltage detection circuit 108 detects a voltage value of an electrolytic capacitor included in the main circuit DC unit 107. The value is output to the switching control unit 106.

To the switching control unit 106, the power supply voltage amplitude, a current signal, and a DC voltage signal are input. In a normal operating method, the power supply voltage amplitude and the DC voltage are compared to thereby determine whether or not there is a regenerative state, and when the motor is in the regenerative state, a GS release signal is output. At this time, by six gate pulse signals generated by gate pulse waveform generation processing 105, the main circuit element 200 is switched.

To a phase pulse signal generation circuit 102, a voltage of the power supply 1 is input, and the phase pulse signal generation circuit 102 outputs a phase pulse signal synchronized with the voltage. To a phase detection circuit 101, the phase pulse signal is input, and the phase detection circuit 101 performs PLL processing and generates a power supply phase signal. To the gate pulse waveform generation processing 105, the power supply phase signal is input and the gate pulse waveform generation processing 105 generates six gate pulse waveforms. Here, relating to an input to the phase detection circuit 101, in place of the phase pulse signal generation circuit 102, for example, an output from a phase detecting transformer or the like may be used.

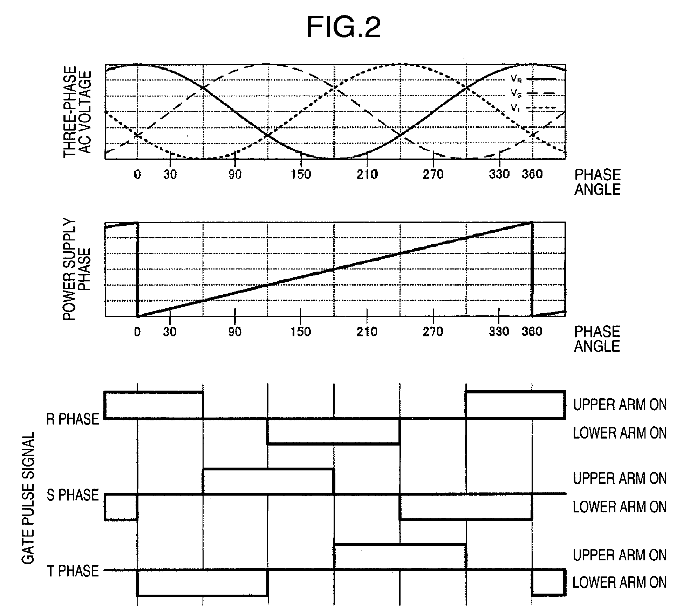

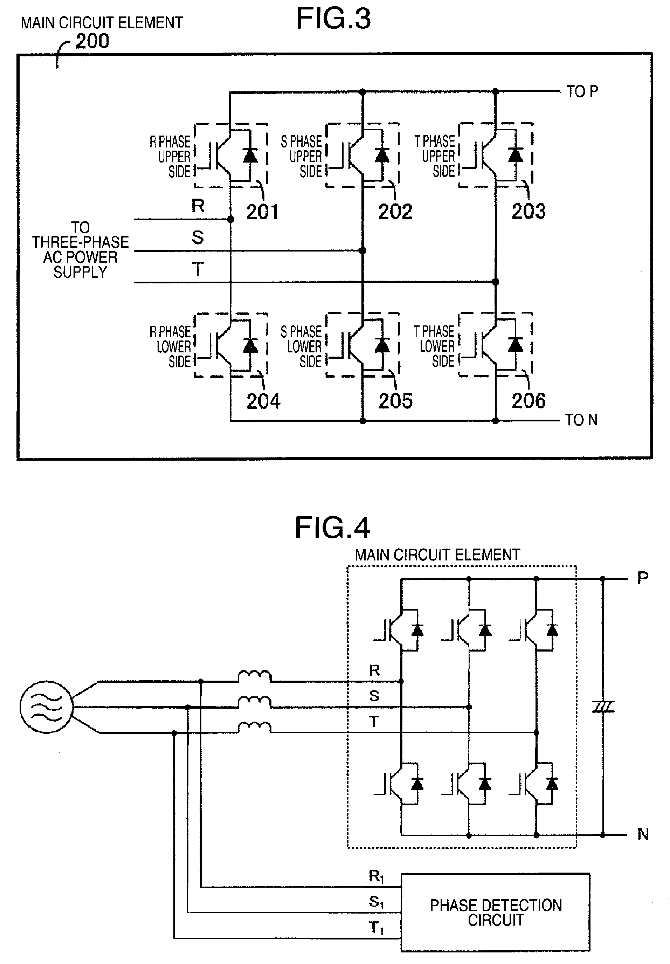

A relationship between the power supply phase signal and the gate pulse signal is illustrated in FIG. 2. Here, a reference of the phase is arbitrary. As illustrated in FIG. 2, the gate pulse signal changes switching of six main circuit elements (R phase upper side 201, S phase upper side 202, T phase upper side 203, R phase lower side 204, S phase lower side 205, and T phase lower side 206 (see FIG. 3)) included in the main circuit element 200 in accordance with an angle of a power supply phase.

As terminals on the AC side of the regenerative converter, R, S, and T terminals connected to the main circuit element 200 and R1, S1, and T1 terminals connected to the phase pulse signal generation circuit 102 are used. The R1, S1, and T1 terminals are connected directly to the power supply 1, and on the other hand, the R, S, and T terminals are connected to the power supply 1 via the reactor. Normally, this reactor is not stored in the same chassis and is installed separately, and therefore the above-described wiring is performed on the user side.

FIG. 4 illustrates appropriate wiring (hereinafter, normal wiring), and on the other hand, the miswiring described at the front of the present embodiment indicates a case in which an order of the R, S, and T terminals connected to the main circuit element 200 and that of the R1, S1, and T1 terminals connected to the phase pulse signal generation circuit 102 are different with each other and the wiring is performed. It is impossible to perform a normal operation in this state.

Hereinafter, calculating formulae necessary for determination during the miswiring will be described.

When the power supply phase of FIG. 2 is used, voltages in the power supply 1 are represented by MATH. 1, MATH. 2, and MATH. 3.

[MATH. 1]

$$V_R = V \cos \theta$$

[MATH. 2]

$$V_S = V \cos(\theta - 120)$$

[MATH. 3]

$$V_T = V \cos(\theta + 120)$$

$V_R$ represents a phase voltage of the R phase, $V_S$ represents a phase voltage of the S phase, and $V_T$ represents a phase voltage of the T phase. When $V_{ac}$ is set to an effective value of a line voltage, the phase voltage is represented by MATH. 4.

[MATH. 4]

$$V = \sqrt{2} \times \frac{V_{ac}}{\sqrt{3}} [V]$$

Further, when charging is completed in the electrolytic capacitor included in the main circuit DC unit 107 and an AC voltage becomes a rectified voltage through diodes of the main circuit element 200, a DC voltage $V_{dc}$ on the side of the main circuit DC unit 107 is represented by MATH. 5.

[MATH. 5]

$$V_{dc} = \sqrt{2} V_{ac}$$

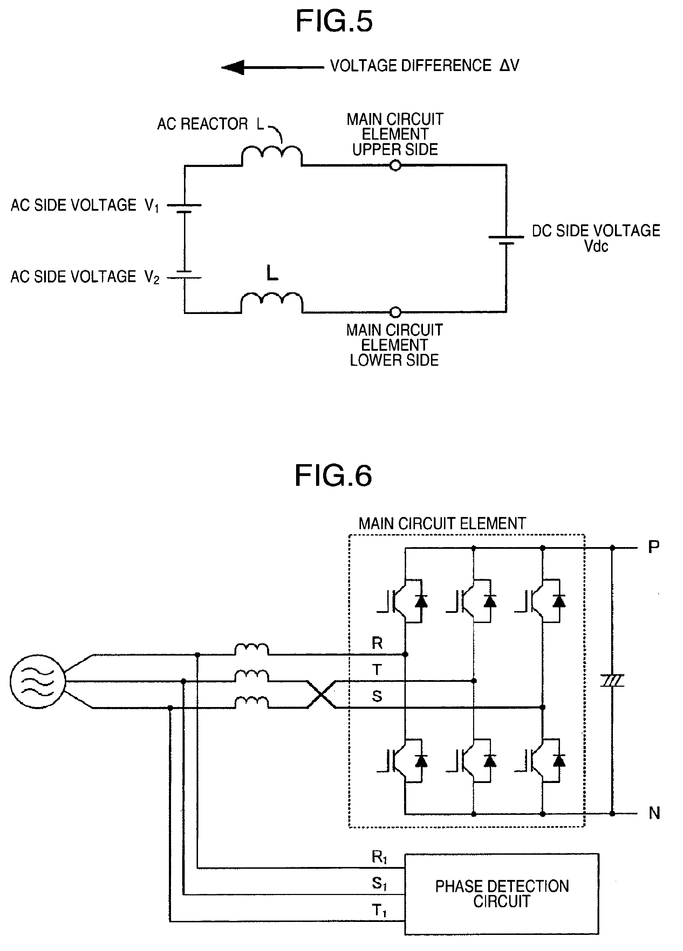

Here, when the main circuit element is driven by gate pulse signals illustrated in FIG. 3 during the normal wiring, a voltage applied to the reactors is considered. As can be seen in FIG. 3, in a conductive state of the main circuit element, an upper arm and a lower arm are turned ON one by one in an arbitrary phase, respectively. For the phase $\theta$, a phase in which the upper arm is turned ON is a phase in which a voltage is highest, and on the other hand, a phase in which the lower arm is turned ON is a phase in which a voltage is lowest. When only a circuit of the main circuit element that is turned ON is taken out, it is illustrated in FIG. 5. At this time, V1 is a voltage of the phase in which the upper arm is turned ON and V2 is a voltage of the phase in which the lower arm is turned ON.

In a central position of each gate pulse signal illustrated in FIG. 3, phases $\theta$ are 30, 90, 150, 210, 270, and 330 degrees. When a difference between the phase $\theta$ and a nearest angle of these angles is set to $\alpha$, a voltage difference between V1 and V2, namely, a line voltage in the main circuit element that is turned ON is represented by MATH. 6.

[MATH. 6]

$$V_1 - V_2 = \sqrt{3}V\cos\alpha$$

When MATH. 4 is substituted here, MATH. 7 is obtained.

[MATH. 7]

$$V_1 - V_2 = \sqrt{2}V_{ac}\cos\alpha$$

From the circuit of FIG. 5, a voltage $\Delta V$ generated in the reactor is represented by MATH. 8.

[MATH. 8]

$$\Delta V = -(V_1 - V_2) + V_{dc}$$

A state in which rectification to the DC voltage Vdc is performed is obtained by MATH. 5, and thereby $\Delta V$ is represented by MATH. 9.

[MATH. 9]

$$\Delta V = \sqrt{2}V_{ac}(1 - \cos\alpha)$$

When the voltage difference $\Delta V$ is generated in the reactor, a current $\Delta I$ flowing in the reactor can be obtained by MATH. 10. At this time, $\Delta T$ is set to represent a time [s] and L is set to represent inductance [H] of the AC reactor 4.

[MATH. 10]

$$\Delta I = \frac{\Delta V}{2L}\Delta T$$

Here, the voltage $\Delta V$ generated in the reactor during the miswiring is calculated. As an example 1, for the terminals R1, S1, and T1 connected to the phase pulse signal generation circuit 102, a case in which the terminals R, T, and S are miswired in sequence on the side of the main circuit element 200 as illustrated in FIG. 6 is considered. At this time, the phase $\theta$ is set to 30 degrees. Considering a circuit of FIG. 5, during the normal wiring, a phase voltage of the R phase is applied to V1 and a phase voltage of the T phase is applied to V2; here, the S phase and the T phase are considered inversely, and therefore a phase voltage of the S phase is applied to V2. The voltage $\Delta V$ generated here is obtained from MATH. 8, and when a power supply voltage is 200V, a voltage of approximately 140V is generated. The current $\Delta I$ flowing at this time is obtained from MATH. 10.

When voltages generated in the case in which the terminals are connected in an arbitrary wiring pattern are considered in a central point of each gate pulse signal, namely, in an angle of $\alpha = 0$, they are illustrated in table 1.

[Table 1]

| POWER SUPPLY PHASE ANGLE [DEGREE] | | | 30 | | | 90 | | | 150 | | | 210 | | | 270 | | | 330 | | |
|---|---|---|---|---|---|---|---|---|---|---|---|---|---|---|---|---|---|---|---|---|
| VOLTAGE PHASE | | | R | S | T | R | S | T | R | S | T | R | S | T | R | S | T | R | S | T |
| THREE-PHASE AC VOLTAGE [V] | | | $\frac{V_{ac}}{\sqrt{2}}$ | 0 | $-\frac{V_{ac}}{\sqrt{2}}$ | 0 | $\frac{V_{ac}}{\sqrt{2}}$ | $-\frac{V_{ac}}{\sqrt{2}}$ | $-\frac{V_{ac}}{\sqrt{2}}$ | $\frac{V_{ac}}{\sqrt{2}}$ | 0 | $-\frac{V_{ac}}{\sqrt{2}}$ | 0 | $\frac{V_{ac}}{\sqrt{2}}$ | 0 | $-\frac{V_{ac}}{\sqrt{2}}$ | $\frac{V_{ac}}{\sqrt{2}}$ | $\frac{V_{ac}}{\sqrt{2}}$ | $-\frac{V_{ac}}{\sqrt{2}}$ | 0 |
| GATE PULSE SIGNAL | UPPER | | R PHASE | | | S PHASE | | | S PHASE | | | T PHASE | | | T PHASE | | | R PHASE | | |
| | LOWER | | T PHASE | | | T PHASE | | | R PHASE | | | R PHASE | | | S PHASE | | | S PHASE | | |
| VOLTAGE DIFFERENCE OF EACH WIRING PATTERN | (1) R S T | 0 | 0 | 0 | 0 | 0 | 0 | 0 | 0 | 0 | 0 | 0 | 0 | 0 | 0 | 0 | 0 | 0 | 0 | |
| | (2) R T S | ΔV1 | 0 | ΔV1 | 0 | ΔV3 | ΔV3 | ΔV1 | ΔV1 | 0 | ΔV1 | 0 | ΔV1 | 0 | ΔV3 | ΔV3 | ΔV1 | ΔV1 | 0 | |
| | (3) S R T | ΔV1 | 0 | ΔV1 | 0 | ΔV1 | ΔV1 | ΔV3 | ΔV3 | 0 | ΔV1 | 0 | ΔV1 | 0 | ΔV1 | ΔV1 | ΔV3 | ΔV3 | 0 | |
| | (4) T R S | ΔV2 | 0 | ΔV2 | 0 | ΔV2 | ΔV2 | ΔV2 | ΔV2 | 0 | ΔV2 | 0 | ΔV2 | 0 | ΔV2 | ΔV2 | ΔV2 | ΔV2 | 0 | |
| | (5) S T R | ΔV2 | 0 | ΔV2 | 0 | ΔV2 | ΔV2 | ΔV2 | ΔV2 | 0 | ΔV2 | 0 | ΔV2 | 0 | ΔV2 | ΔV2 | ΔV2 | ΔV2 | 0 | |
| | (6) T S R | ΔV3 | 0 | ΔV3 | 0 | ΔV1 | ΔV1 | ΔV1 | ΔV1 | 0 | ΔV3 | 0 | ΔV3 | 0 | ΔV1 | ΔV1 | ΔV1 | ΔV1 | 0 | |

※1 $\Delta V1 = \frac{V_{ac}}{\sqrt{2}}$

※2 $\Delta V2 = 3 \times \Delta V1$

※3 $\Delta V3 = 4 \times \Delta V1$

It is seen from table 1 that a voltage difference is generated in an arbitrary phase even in any wiring pattern during the miswiring. At this time, a magnitude relation between the voltages is ΔV1<ΔV2<ΔV3.

On the other hand, in the case of the normal wiring, the voltage difference is prevented from being generated in the reactor even in any phase of the table. Therefore, when the main circuit element is driven in $\alpha$ =0 in the gate pulse of FIG. 3, it is possible to understand whether or not the normal wiring is performed depending on whether or not a flowing current is approximately zero.

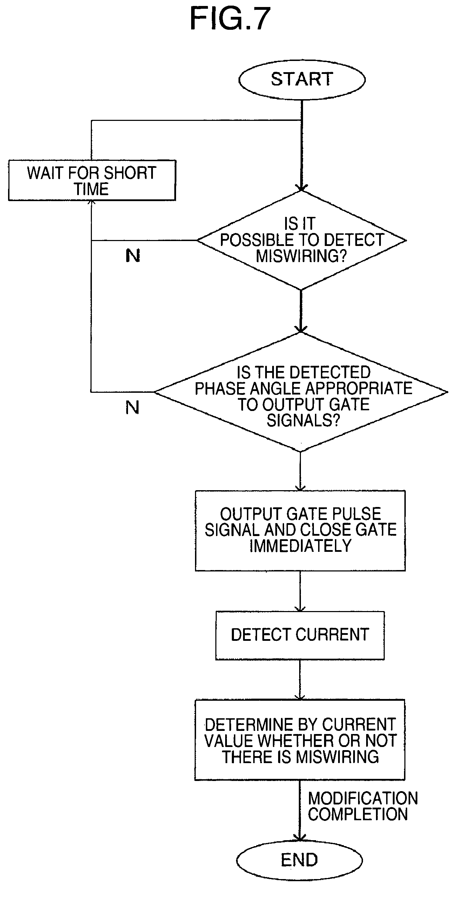

Hereinafter, a specific detection method of the miswiring will be described by using a flowchart of FIG. 7.

First, whether or not conditions are satisfied that it is possible to detect the miswiring is determined. The conditions include that rectification to a DC voltage is performed, a CT offset is finished, the PLL converges for a phase detection, and the like. Determination of the rectified voltage can be performed by comparing the power supply voltage amplitude and the DC voltage. If the conditions are not satisfied, a confirmation is repeated until the conditions are satisfied after a shorter standby time.

Next, waiting is performed until a phase appropriate to an output of the gate pulse signal. If the phase is not appropriate, waiting of a shorter time is performed to repeat the confirmation from a first condition. Relating to a phase angle θ to be detected, a current flowing in three phases becomes approximately zero, and therefore an angle such that a voltage of any one phase of the three phases becomes 0V is appropriate to the detection. The angles are six angles of 30, 90, 150, 210, 270, and 330 degrees. Therefore, the detection is performed by a phase having a value that an angle difference $\alpha$ is small as far as possible is recommended. However, since the detection cannot be always accurately performed by the above-described six phases, a gate can be opened in a phase that deviates in some degrees by adjusting the threshold.

If a position of the phase is preferable, the gate pulse signal is output and the output is stopped after a fixed time has passed. Since a current value is proportional to a time at which this gate pulse signal is output, the time is determined on the basis of a current detection accuracy or an overcurrent level. Thereafter, a current near to a peak value is detected. As illustrated in table 1, a current becomes approximately zero in the case of the normal wiring, and on the other hand, the current flows during the miswiring. Accordingly, depending on whether an appropriate threshold is determined and the current value is equal to or greater than the threshold, it is possible to perform determination whether the wiring is normal or missing.

Relating to a way of determining the threshold, since a current value to be generated is represented by MATH. 10, the threshold is determined in accordance with ΔV, ΔT, or L. For example, as an L value of the reactor is greater, a value of a flowing current decreases, and therefore the threshold can be decreased. Further, for example, since ΔV during the miswiring is proportional to the power supply voltage, the threshold can be determined depending on the power supply voltage.

The flowing current is calculated by MATH. 10, but the detected current values include errors of various detectors. Further, the voltage difference of table 1 is considered on the basis of the circuit of FIG. 5; however, a current to the connected inverter or the like is also generated, and therefore the voltage difference of table 1 deviates from a value calculated by MATH. 10. Further, when the power supply is not balanced or harmonic distortion is included, a considerable current flows even in the normal wiring, and therefore a large threshold needs to be taken. In these cases, a method for using a plurality of phases, performing a determination, and the like is effective.

When the above-described method is used, the time to output the gate pulse signal is adjusted, and thereby the miswiring can be detected on the premise that a current is limited to a safe level. Therefore, abnormal operations or breakage of the main circuit element to be switched can be prevented.

Further, detection of the miswiring is performed before the operation, and thereby an alarm can be issued more safely than that at the start of the operation.

SECOND EMBODIMENT

In the present embodiment, a function of performing operations in a state of the miswiring when there is the miswiring is determined will be described.

When a means of the first embodiment is used, it is possible to determine whether or not there is the miswiring. In addition to the above, in the present embodiment, an actual wiring pattern is detected, and as described later, a phase to be switched in the main circuit element is changed and thereby it is possible to perform operations in a state of actual wiring.

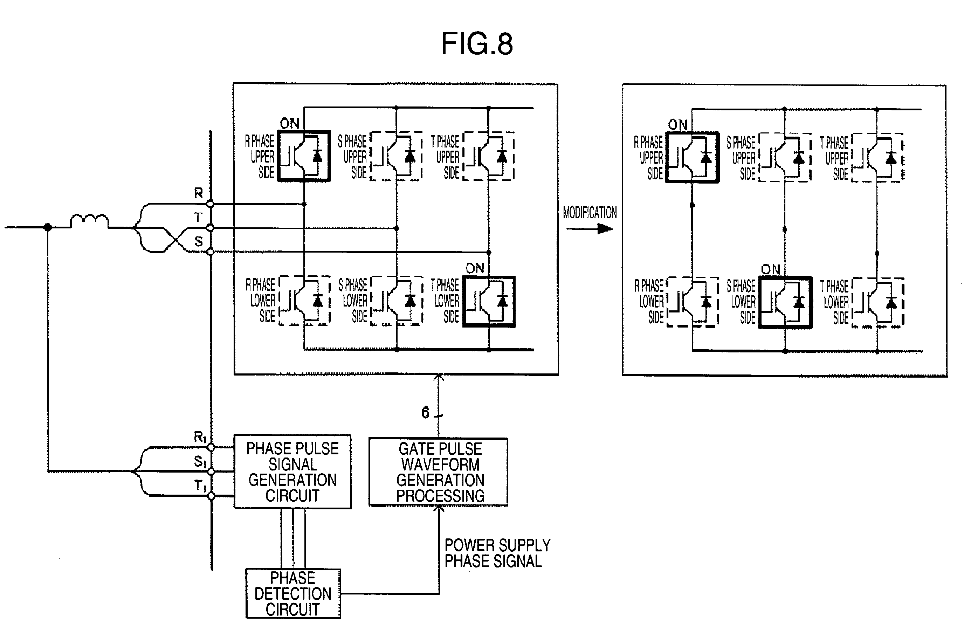

First, a method for changing a phase to be switched in the main circuit element with use of conditions of the example 1 of the first embodiment will be described. In the phases illustrated in table 1, a phase to be switched in the main circuit element is a phase in which the three-phase AC voltage is not zero. As illustrated in FIG. 8, a phase in which a voltage value is a positive value switches an element on the upper side of the main circuit element, and a phase in which the voltage value is a negative value switches an element on the lower side thereof. In the example 1, the S phase and the T phase are wired inversely to the AC side of the main circuit element 200. Therefore, instead of switching the main circuit element on the lower side of the T phase, the main circuit element on the lower side of the S phase to which a voltage of the T phase is applied is switched, and thereby the switching can be performed in accordance with the actual wiring.

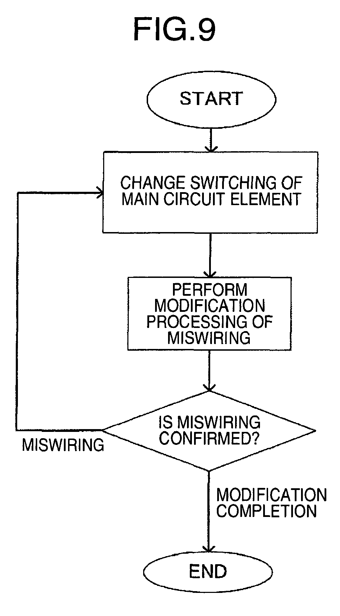

Next, a method for detecting the actual wiring pattern will be described. Here, the miswiring detection method described in the first embodiment is used. The wiring is assumed to be performed in a certain miswiring pattern and descriptions will be made with reference to a flowchart of FIG. 9. A gate pulse signal is first output and detection of a current is performed. When there is the miswiring can be here confirmed, a phase to be switched in the main circuit element is changed in accordance with the miswiring pattern (1) of table 1. Here, the gate pulse signal is also output and whether or not a current flows is confirmed. In the case in which a current flows, the miswiring pattern (2) is adopted and also whether or not a current flows is confirmed. As described above, six types of all the miswiring patterns are tried in sequence, and thereby a pattern in which no current flows, namely, the actual wiring pattern can be detected.

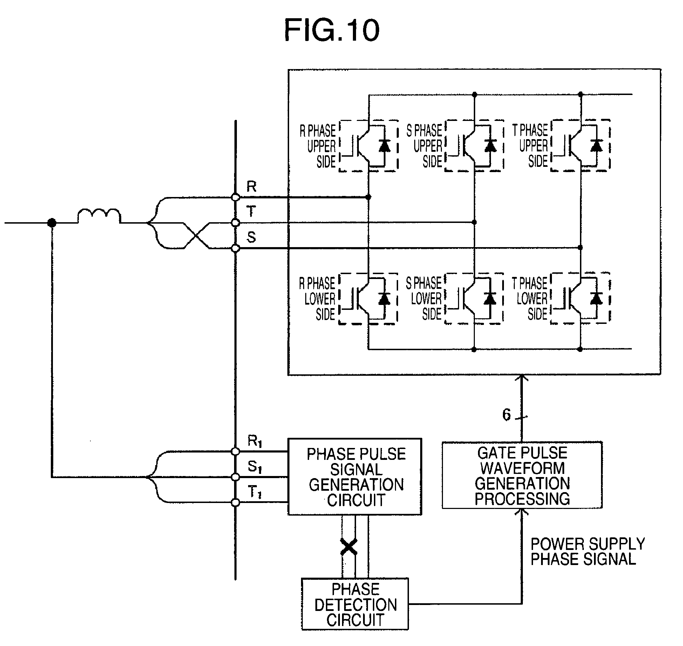

Further, suppose, for example, that for the terminals R1, S1, and T1 connected to the phase pulse signal generation circuit 102 as illustrated in FIG. 10, an order of the terminals connected to the main circuit element 200 is set to that of R, T, and S. At this time, in the phase pulse signal generation circuit 102, phase pulse signals (an order of this case is R1, T1, and S1) interchanged in accordance with the order of the terminals connected to the main circuit element 200 are output, and thereby the miswiring can be modified.

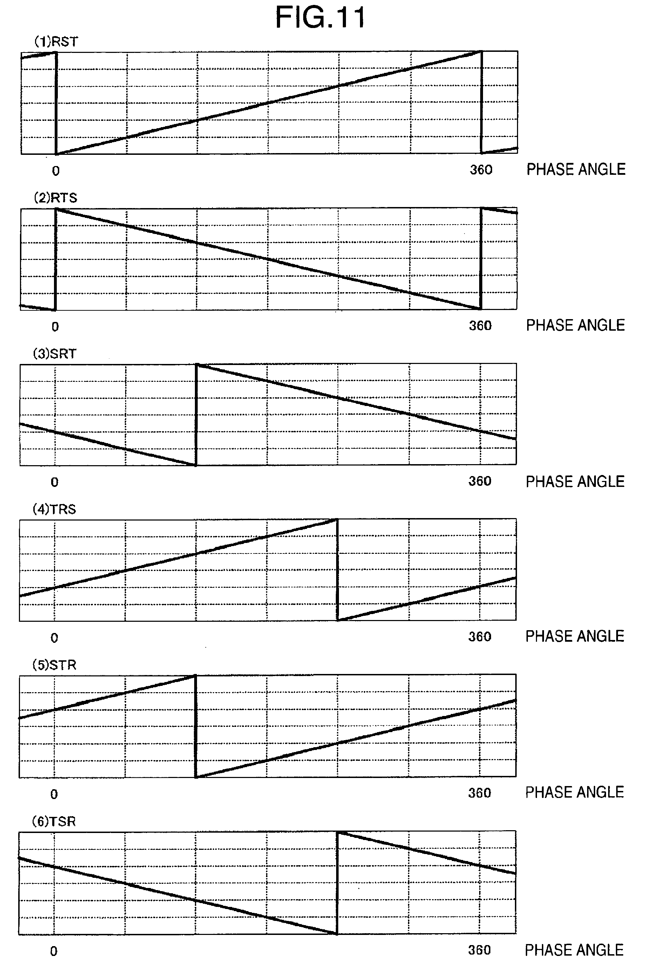

Further, the miswiring can be modified by deviating the power supply phase. FIG. 11 is a diagram in which when the terminals connected to the phase pulse signal generation circuit 102 are set to R1, S1, and T1, the power supply phases at the time of changing the phases to be switched in the main circuit element are collected in each wiring pattern. As can be seen in FIG. 11, a tilt of the power supply phase or a position of a zero point changes in each wiring pattern. Therefore, the power supply phase is changed in accordance with each wiring pattern, and thereby the miswiring can be modified.

Hereinafter, a specific example in which the power supply phase is modified will be described. From FIG. 11, when a case in which the terminals are connected in the miswiring pattern of (3) is taken as an example, the power supply phase may be changed so that (1) being the power supply phase in the normal wiring is the power supply phase of (3). As a method, since (3) is a reverse phase against a normal phase of (1), the power supply phase is first reversed and then the power supply phase is advanced by 120 degrees to thereby modify the power supply phase.

THIRD EMBODIMENT

In the present embodiment, a function of estimating an actual wiring pattern when there is the miswiring is determined will be described.

In the present embodiment, used are effects that all the miswiring patterns are not tried as described in the second embodiment but the actual wiring can be detected, an extra voltage application to the main circuit is reduced, and the standby time up to an operation is shortened.

For a method for performing an estimation, an applicable current value may be found out from table 1 on the basis of current values obtained at a first current detection performed at the time of power-on and a pattern that is applicable to the current value may be determined.

Further, when the main circuit element is switched by a method of the second embodiment in accordance with

**EP 2 980 978 A1**

the above-described estimated pattern, no current flows. It is possible to simply confirm by this method whether or not the above-described estimation is correct.

FOURTH EMBODIMENT

In the present embodiment, a function of detecting the miswiring by detecting a voltage will be described.

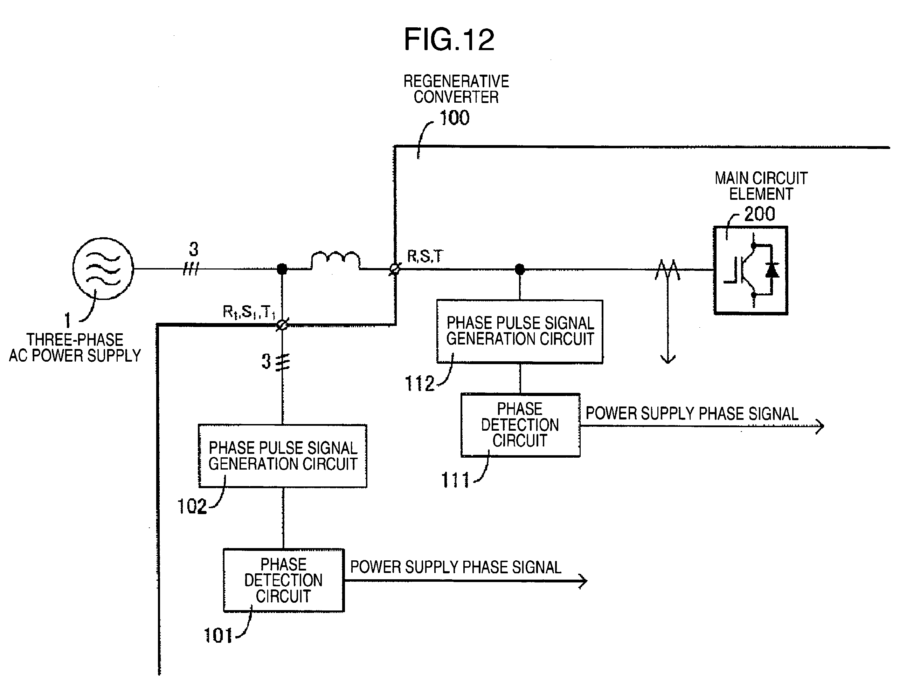

A method for determining whether or not there is the miswiring on the basis of the voltage detection will be described below. As illustrated in FIG. 12, a phase detection circuit 111 and a phase pulse signal generation circuit 112 are first provided on the AC side of the main circuit element 200. These circuits perform the same processing as that of the phase detection circuit 101 and the phase pulse signal generation circuit 102 described in the first embodiment. Accordingly, the power supply phase signals output by the phase detection circuit 101 and the phase detection circuit 111 are compared with each other, and thereby it is possible to perform determination that if the power supply phase signals are the same, there is the normal wiring, whereas if the power supply phase signals are different, there is the miswiring.

As described above, according to the present invention, it is possible to provide a power supply regenerative device that is capable of confirming phases at a power start-up, detecting all the miswiring, and notifying users of correct wiring phases regardless of startup timing of the power supply for control.

**Claims**

1.   An electric power conversion device comprising:

a state data detection unit that detects state data input to a regenerative converter from a three-phase power supply during switching of a main circuit terminal;
a comparison unit that compares the state data detected by the state data detection unit and a predetermined threshold; and
a determination unit that determines a wiring state between the three-phase power supply entering a main circuit and the three-phase power supply entering a phase detection circuit based on comparison results from the comparison unit.

2.   The electric power conversion device according to claim 1, wherein the state data detected by the state data detection unit is either a current value or a voltage value.

3.   The electric power conversion device according to claim 1, further comprising a display unit that displays an alarm when there is a miswiring state is determined by the determination unit.

4.   The electric power conversion device according to claim 1, wherein the predetermined threshold used by the comparison unit is zero.

5.   The electric power conversion device according to claim 1, wherein when there is a miswiring state is determined by the determination unit, a connection state between the regenerative converter and the phase detection circuit is changed.

FIG.1

# FIG.2

## FIG.3

MAIN CIRCUIT ELEMENT

200

TO P

R PHASE
UPPER
SIDE

201

S PHASE
UPPER
SIDE

202

T PHASE
UPPER
SIDE

203

TO
THREE-PHASE
AC POWER
SUPPLY

R

S

T

R PHASE
LOWER
SIDE

204

S PHASE
LOWER
SIDE

205

T PHASE
LOWER
SIDE

206

TO N

## FIG.4

MAIN CIRCUIT ELEMENT

P

R

S

T

N

$R_1$

$S_1$

$T_1$

PHASE DETECTION
CIRCUIT

11

# FIG.5

← VOLTAGE DIFFERENCE ΔV

AC REACTOR L

MAIN CIRCUIT
ELEMENT
UPPER SIDE

AC SIDE VOLTAGE $V_1$

AC SIDE VOLTAGE $V_2$

L

DC SIDE VOLTAGE
Vdc

MAIN CIRCUIT
ELEMENT
LOWER SIDE

# FIG.6

MAIN CIRCUIT ELEMENT

P

R

T

S

N

$R_1$

$S_1$

$T_1$

PHASE DETECTION
CIRCUIT

# FIG.7

START

WAIT FOR SHORT TIME

IS IT POSSIBLE TO DETECT MISWIRING?

N

IS THE DETECTED PHASE ANGLE APPROPRIATE TO OUTPUT GATE SIGNALS?

N

OUTPUT GATE PULSE SIGNAL AND CLOSE GATE IMMEDIATELY

DETECT CURRENT

DETERMINE BY CURRENT VALUE WHETHER OR NOT THERE IS MISWIRING

MODIFICATION COMPLETION

END

## FIG.8

MODIFICATION

POWER SUPPLY
PHASE SIGNAL

EP 2 980 978 A1

# FIG.9

START

CHANGE SWITCHING OF
MAIN CIRCUIT ELEMENT

PERFORM
MODIFICATION
PROCESSING OF
MISWIRING

IS MISWIRING
CONFIRMED?

MISWIRING

MODIFICATION
COMPLETION

END

# FIG.10

R PHASE UPPER SIDE

S PHASE UPPER SIDE

T PHASE UPPER SIDE

R

T

S

R PHASE LOWER SIDE

S PHASE LOWER SIDE

T PHASE LOWER SIDE

6

$R_1$

$S_1$

$T_1$

PHASE PULSE SIGNAL GENERATION CIRCUIT

GATE PULSE WAVEFORM GENERATION PROCESSING

POWER SUPPLY PHASE SIGNAL

PHASE DETECTION CIRCUIT

# FIG.11

(1)RST

0            360    PHASE ANGLE

(2)RTS

0            360    PHASE ANGLE

(3)SRT

0            360    PHASE ANGLE

(4)TRS

0            360    PHASE ANGLE

(5)STR

0            360    PHASE ANGLE

(6)TSR

0            360    PHASE ANGLE

# FIG.12

REGENERATIVE
CONVERTER
100

MAIN CIRCUIT
ELEMENT
200

1
THREE-PHASE
AC POWER SUPPLY

3

$R_1,S_1,T_1$

R,S,T

3

PHASE PULSE SIGNAL
GENERATION CIRCUIT

112

PHASE PULSE SIGNAL
GENERATION CIRCUIT

102

PHASE
DETECTION
CIRCUIT

111

POWER SUPPLY PHASE SIGNAL

PHASE
DETECTION
CIRCUIT

101

POWER SUPPLY PHASE SIGNAL

EP 2 980 978 A1

## INTERNATIONAL SEARCH REPORT

| International application No. |
| --- |
| PCT/JP2013/083816 |

### A. CLASSIFICATION OF SUBJECT MATTER
*H02M7/48*(2007.01)i, *H02M7/12*(2006.01)i, *H02M7/219*(2006.01)i

According to International Patent Classification (IPC) or to both national classification and IPC

### B. FIELDS SEARCHED

Minimum documentation searched (classification system followed by classification symbols)
H02M7/48, H02M7/12, H02M7/219

Documentation searched other than minimum documentation to the extent that such documents are included in the fields searched
| | | | |
| --- | --- | --- | --- |
| Jitsuyo Shinan Koho | 1922–1996 | Jitsuyo Shinan Toroku Koho | 1996–2014 |
| Kokai Jitsuyo Shinan Koho | 1971–2014 | Toroku Jitsuyo Shinan Koho | 1994–2014 |

Electronic data base consulted during the international search (name of data base and, where practicable, search terms used)

### C. DOCUMENTS CONSIDERED TO BE RELEVANT

| Category* | Citation of document, with indication, where appropriate, of the relevant passages | Relevant to claim No. |
| --- | --- | --- |
| A | JP 2012-249494 A (Hitachi Industrial Equipment System Co., Ltd.), 13 December 2012 (13.12.2012), entire text; all drawings (Family: none) | 1-5 |
| A | JP 8-251927 A (Hitachi, Ltd.), 27 September 1996 (27.09.1996), entire text; all drawings (Family: none) | 1-5 |
| A | JP 2012-16206 A (Hitachi, Ltd.), 19 January 2012 (19.01.2012), entire text; all drawings (Family: none) | 1-5 |

☐ Further documents are listed in the continuation of Box C.  ☐ See patent family annex.

| | |
| --- | --- |
| * Special categories of cited documents: | "T" later document published after the international filing date or priority date and not in conflict with the application but cited to understand the principle or theory underlying the invention |
| "A" document defining the general state of the art which is not considered to be of particular relevance | |
| "E" earlier application or patent but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
| --- | --- |
| 31 March, 2014 (31.03.14) | 08 April, 2014 (08.04.14) |

| Name and mailing address of the ISA/ Japanese Patent Office | Authorized officer |
| --- | --- |
| Facsimile No. | Telephone No. |

Form PCT/ISA/210 (second sheet) (July 2009)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 10248260 A